Europäisches Patentamt

European Patent Office

Office européen des brevets

(19)

(11) Veröffentlichungsnummer : **0 163 921**
**B1**

# (12) EUROPÄISCHE PATENTSCHRIFT

(45) Veröffentlichungstag der Patentschrift :
**17.08.88**

(21) Anmeldenummer : **85105138.3**

(22) Anmeldetag : **26.04.85**

(51) Int. Cl.⁴ : **H 04 L 11/16**

(54) **Messdatenverarbeitungsanlage.**

(30) Priorität : **07.05.84 DE 3416842**

(43) Veröffentlichungstag der Anmeldung :
**11.12.85 Patentblatt 85/50**

(45) Bekanntmachung des Hinweises auf die Patenterteilung : **17.08.88 Patentblatt 88/33**

(84) Benannte Vertragsstaaten :
**DE FR GB NL**

(56) Entgegenhaltungen :
**EP-A- 0 086 577**
**EP-A- 0 131 289**
**DE-A- 2 644 616**
**GB-A- 2 064 919**
**GB-A- 2 094 110**
**IBM TECHNICAL DISCLOSURE BULLETIN, Band 19, Nr. 10, März 1977, Seiten 3824-3828, New York, US; G.J. LAURER u.a.: "Automatic loop reconfigurator"**
**IBM TECHNICAL DISCLOSURE BULLETIN, Band 14, Nr. 12, Mai 1972, Seiten 3617-3618, New York, US; L.M. AUDRETSCH, Jr. u.a.: "Turn-around fault bypass in single-rail loop communication network"**

(73) Patentinhaber : **Siemens Aktiengesellschaft Berlin und München**
**Wittelsbacherplatz 2**
**D-8000 München 2 (DE)**

(72) Erfinder : **Schwaier, Arnold, Dipl.-Ing.**
**Hermann-Löns-Weg 28**
**D-7516 Karlsbad 1 (DE)**

EP 0 163 921 B1

## Beschreibung

Die Erfindung bezieht sich auf eine Meßdatenverarbeitungsanlage gemäß den Merkmalen a), b) und c) des Anspruchs 1.

Es ist bekannt, gemäß den Merkmalen a) und b) des Anspruchs 1 bei Meßdatenverarbeitungsanlagen alle Meßumformer an eine Ringbusleitung anzuschließen, damit die Systemverfügbarkeit auch bei Unterbrechungen (z. B. bei Leitungsbruch) so groß wie möglich gehalten wird. Werden die Meßumformer lediglich an parallel, nicht ringförmig verlegte Signalleitungen angeschlossen, so fällt bei Einzelbruch einer Ader das zugeordnete Meßwertsignal aus. Beim Einsatz multiplexer Systeme mit serieller Nutzung des Signalweges für mehrere Meßumformer fallen die Meßwertsignale mehrerer Meßumformer aus. Tritt jedoch eine Unterbrechung bei einer Ringbusleitung auf, so fallen zunächst keine Meßwertsignale aus ; erst ein weiterer Bruch an einer anderen Stelle der Ringbusleitung führt zu einem Ausfall der zwischen den Bruchstellen liegenden Meßumformer.

Bei einer bekannten Datenverarbeitungsanlage (IBM Technical Disclosure Bulletin, Band 19, Nr. 10, März 1977, Seiten 3824 bis 3828) ist hinsichtlich der Merkmale a), b) und c) des Anspruchs 1 bekannt, eine Vielzahl von Terminals an einen Ringbus anzuschalten und eine Bussteuerung in den Ringbus derart einzufügen, daß zwei Schnittstellen zur Untersuchung der beiden Richtungen des Ringbusses im Fehlerfall gebildet werden. Bei einer Unterbrechung oder einem Kurzschluß werden hier zwei Subsysteme beiderseits der Fehlerstelle gebildet, die jeweils separat von der Bussteuerung untersucht werden, so daß eine Fehlerlokalisierung möglich wird. Hierzu sind eine Vielzahl von Kontroll- und Initialisierungsschritten notwendig, die der eigentlichen Fehlerortsbestimmung vorgeschaltet sind.

Der Erfindung liegt die Aufgabe zugrunde, eine Meßdatenverarbeitungsanlage zu schaffen, bei der eine schnelle und sichere Erkennung sowie Lokalisierung von Unterbrechungen am Ringbus möglich ist.

Zur Lösung dieser Aufgabe weist eine Meßdatenverarbeitungsanlage die Merkmale d) und e) des Anspruchs 1 auf, die in erfinderischer Weise mit den Merkmalen a), b) und c) kombiniert sind. Durch die Schaffung von zwei Schnittstellen an der Bussteuerung kann an jeder Schnittstelle eine Prüfung der Signale auf ihre Vollständigkeit vorgenommen werden. Werden Fehler in den Signalen festgestellt oder sind nicht alle Signale vorhanden, so vergleicht die angeschaltete Bussteuerung die vorhandenen Signale beispielsweise mit einem in die zentrale Datenverarbeitungsanlage eingelesenen Muster für die Signalstruktur und ermöglicht eine entsprechende Fehlermeldung.

Eine Prüfung der Signale auf ihre Vollständigkeit ist dadurch möglich, daß an vorgegebenen Stellen des Ringbusses Trennstellen angebracht sind, mit denen eine Simulation von Leitungsbrüchen durchführbar ist. Dies ermöglicht, daß in einer Lernphase bei der Installation der Meßdatenverarbeitungsanlage mit den Trennstellen Leitungsbrüche simuliert werden, so daß eine Lokalisation der Trennstellen und somit nach der Lernphase auch eine Lokalisation von tatsächlichen Bruchstellen Stattfinden kann.

Bei dieser erfindungsgemäßen Anwendung kann mit der Bussteuerung die vorhandene Anzahl der empfangenen Meßwertsignale mit einem eingelesenen Muster verglichen werden.

Die Muster werden für signifikante vorgegebene Trennstellen, beispielsweise bei Inbetriebnahme der Meßdatenverarbeitungsanlage, gelernt. Hiermit ist eine grobe Lokalisierung der Fehlstelle möglich, eine Feinlokalisierung kann beispielsweise aus einem abgespeicherten und auf einem Bildschirm darstellbaren Topologieplan der Anlage aus der Information der ausgefallenen Meßumformer entnommen werden.

Besonders vorteilhafte Ausführungsformen der Kopplung des mindestens einen Interfaces und der mindestens einen Bussteuerung an den Ringbus sind mit den abhängigen Ansprüchen 2 bis 4 angegeben.

Die Erfindung wird anhand der Figuren erläutert, wobei Figur 1 eine Meßdatenverarbeitungsanlage mit einem Ringbus in bekannter Bauweise, Figur 2 eine Ausführungsform der erfindungsgemäßen Meßdatenverarbeitungsanlage, die Figuren 3 bis 6 besondere Ausführungsformen der Schnittstellen zwischen der Bussteuerung und dem Ringbus und

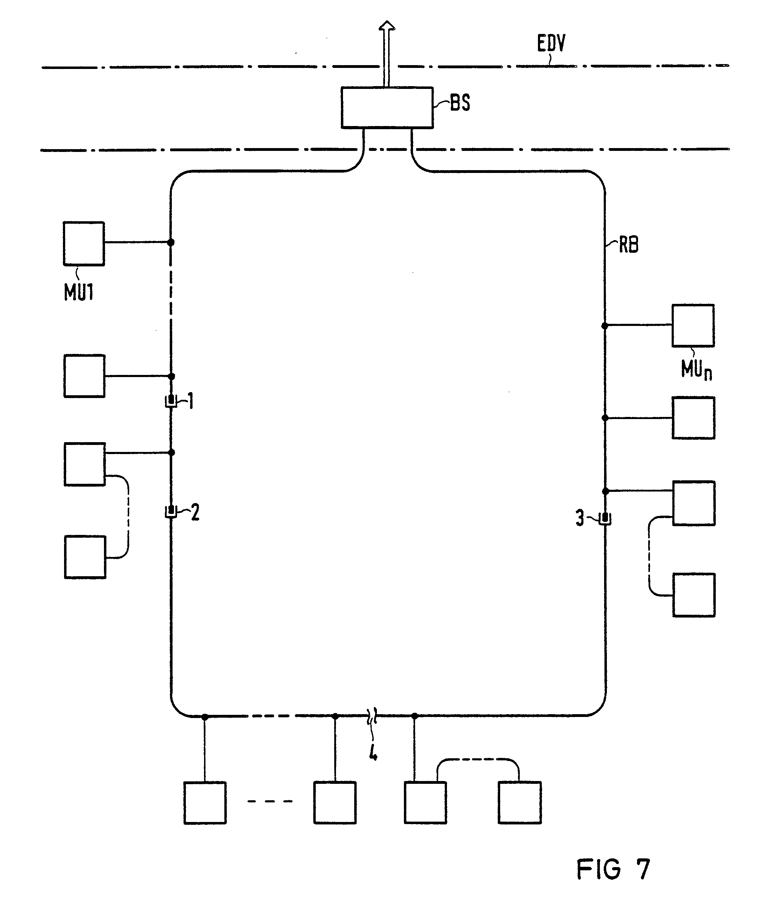

Figur 7 eine Ausführungsform des Ringbusses mit vorgegebenen Trennstellen darstellen.

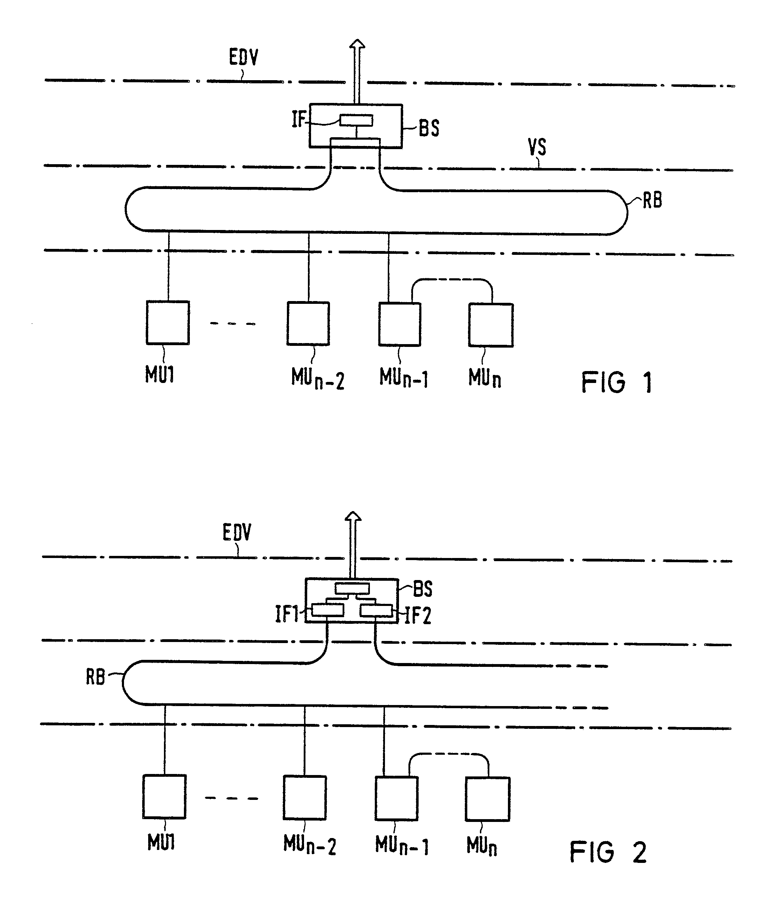

Bei einer bekannten Meßdatenverarbeitungsanlage ist in der Figur 1 ein Ringbus RB dargestellt, an den eine Anzahl Meßumformer MU1 ... MUₙ als Feldgeräte angeschaltet sind. An einer Verknüpfungsstelle VS des Ringbusses RB ist eine Bussteuerung BS angeschaltet, die ein Interface IF zur Prüfung der Meßwertsignale enthält. Die Bussteuerung ist mit einer zentralen Datenverarbeitungsanlage EDV verbunden, die eine Weiterverarbeitung der Meßwertund Steuerungssignale vornimmt.

In der Figur 2 weist eine erfindungsgemäße Bussteuerung BS ein Interface IF1 und ein Interface IF2 auf, die jeweils an ein Ende des auftrennbaren Ringbusses RB angeschaltet sind und mit denen somit eine Prüfung der jeweils an den Schnittstellen ankommenden Meßwertsignale möglich ist.

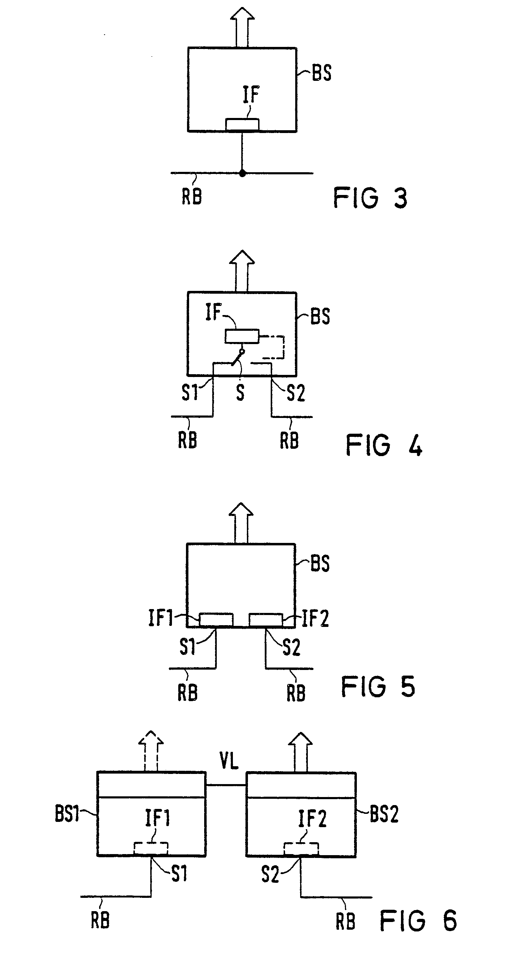

In der Figur 3 ist zunächst noch einmal nur eine Ankopplung der Bussteuerung BS an den Ringbus RB in herkömmlicher Weise dargestellt, mit der bei einem Leitungsbruch zunächst eine Änderung der Meßwertsignale nicht festgestellt werden kann, da von einem Ende der Ringbusleitung auf jeden Fall ein Signal ohne Informationsverlust detektiert wird. Mit der Anordnung nach Figur 4 ist dagegen erreicht, daß mit einer Auftrennung der Ringbusleitung RB und einem Umschalter S eine sequentielle Prüfung der an den somit gebildeten Schnittstellen S1 und S2 ankommenden Meßwertsignale eine Fehlererkennung aufgrund einer Analyse der vorhandenen Rückmeldeadressen von den Meßumformern durchführbar ist.

Gemäß der Ausführungsform nach der Figur 5 weist die Bussteuerung BS ein Interface IF1 und IF2 auf, mit denen jeweils an einem Ende der ankommenden Ringbusleitung RB zeitparallel Fehler in der Signalstruktur erkannt werden können.

Bei der Anordnung nach der Figur 6 ist jedes Interface IF1 und IF2 in eine Bussteuerung BS1 bzw. BS2 integriert, so daß auch die Bussteuerungen redundant ausgelegt sind und eine separate Prüfung zeitparallel für jeweils jede Schnittstelle S1 und S2 durchgeführt werden kann. Ein Vergleich der beiden Prüfergebnisse der Bussteuerungen BS1 bzw. BS2 kann über eine Vergleichsleitung VL durchgeführt werden.

Bei dem in der Figur 7 dargestellten Ringbus RB sind im Verlauf der Ringbusleitung bedienbare Trennstellen 1, 2 und 3 eingebaut, mit denen in einer Lernphase willkürlich Bruchstellen simuliert werden können. Da die Orte und die Adressen dieser Trennstellen bekannt sind, kann aus der Signalstruktur der ankommenden Meßwertsignale eine Lokalisation dieser Trennstellen gelernt werden, die bei tatsächlichen Bruchstellen bzw. Bruchstelle 4 herangezogen werden kann. Aus der Anzahl der an der jeweiligen Schnittstelle vorhandenen rückgemeldeten Adreßsignale kann somit der Ort der vorgegebenen Trennstelle sowie der tatsächlichen Bruchstelle bestimmt werden.


## Patentansprüche

1. Meßdatenverarbeitungsanlage mit folgenden Merkmalen :

a) eine Vielzahl Meßumformer (MU1... MU$_n$) sind an einen Ringbus (RB) angeschaltet,

b) mindestens eine Bussteuerung (BS ; BS1, BS2) ist an den Ringbus (RB) angeschaltet, die mit einer zentralen Datenverarbeitungsanlage (EDV) verbunden ist,

c) im Bereich der Bussteuerung (BS) ist der Ringbus (RB) auftrennbar, so daß zwei Schnittstellen (S1, S2) gebildet werden, an denen mit mindestens einem Interface (IF ; IF1, IF2) Meßumformersignale auf Fehler, z. B. bei Leitungsbruch, untersuchbar sind,

d) an vorgegebenen Stellen des Ringbusses (RB) sind Trennstellen (1, 2, 3) angebracht, mit denen eine Simulation von Leitungsbrüchen durchführbar ist,

e) in einer Lernphase bei der Installation der Meßdatenverarbeitungsanlage werden mit den Trennstellen (1, 2, 3) Leitungsbrüche simuliert, so daß eine Lokalisation der Trennstellen (1, 2, 3) und somit nach der Lernphase auch eine Lokalisation von tatsächlichen Bruchstellen (4) ermöglicht wird.

2. Meßdatenverarbeitungsanlage nach Anspruch 1, dadurch gekennzeichnet, daß das Interface (IF) mit einem Umschalter (S) an jeweils eine der beiden Schnittstellen (S1, S2) anschaltbar ist, so daß eine sequentielle Prüfung durchführbar ist.

3. Meßdatenverarbeitungsanlage nach Anspruch 1, dadurch gekennzeichnet, daß an jede Schnittstelle (S1, S2) ein Interface (IF1, IF2) angeschaltet ist, so daß eine zeitparallele Prüfung durchführbar ist.

4. Meßdatenverarbeitungsanlage nach Anspruch 1 oder Anspruch 3, dadurch gekennzeichnet, daß

jede Schnittstelle (S1, S2) über jeweils ein Interface (IF1, IF2) und jeweils eine Bussteuerung (BS1, BS2) mit der zentralen Datenverarbeitungsanlage (EDV) verbunden ist, wobei

die Bussteuerungen (BS1, BS2) so miteinander verbunden sind, daß ein Vergleich der Prüfergebnisse durchführbar ist.


## Claims

1. Measurement data processing device with the following features :

a) a plurality of measuring transducers (MU1 ... MUn) are connected to a ring bus (RB),

b) at least one bus control (BS ; BS1, BS2) is connected to the ring bus (RB) and is connected to a central data processing device (EDV),

c) in the region of the bus control (BS), the ring bus (RB) can be severed so that two intersection locations (S1, S2) are formed, on which, using at least one interface (IF ; IF1, IF2), measuring transducer signals for faults can be investigated, e.g. in the case of line-break,

d) testing points (1, 2, 3) are provided at predetermined places of the ring bus (RB) and can be used to carry out a simulation of line-breaks,

e) in a learning phase in the installation of the measurement data processing device, line-breaks are simulated by means of the testing points (1, 2, 3), so that the testing points (1, 2, 3) can be located and consequently, after the learning phase, actual break points (4) can also be located.

2. Measurement data processing device according to claim 1, characterised in that the interface (IF) can be connected to one of the two intersection locations (S1, S2) respectively by means of a changeover switch (S), so that a sequential test can be carried out.

3. Measurement data processing device according to claim 1, characterised in that one interface (IF1, IF2) is connected to each intersection location (S1, S2), so that a time-parallel test can be carried out.

4. Measurement data processing device according to claim 1 or claim 3, characterised in that each intersection location (S1, S2) is connected with the central data processing device (EDV) via a respective interface (IF1, IF2) and a respective bus control (BS1, BS2), wherein

the bus controls are connected together in such a way that a comparison of the test results can be carried out.

**Revendications**

1. Installation de traitement de données de mesure, présentant les caractéristiques suivantes :

a) une multiplicité de transducteurs de mesure (MU1 ... MU$_n$) sont raccordés à un bus en anneau (RD),

b) au moins un dispositif (BS ; BS1, BS2) de commande du bus est raccordé au bus annulaire (R2) qui est relié à une installation centrale de traitement de données (EDV),

c) au niveau du dispositif (BS) de commande du bus, le bus en anneau (RB) peut être subdivisé de sorte que l'on obtient deux jonctions (S1, S2), au niveau desquelles on peut étudier, à l'aide d'au moins une interface (IF ; IF1, IF2), des signaux des transducteurs de mesure pour voir s'ils indiquent l'existence de défauts, par exemple dans le cas d'une rupture d'une ligne,

d) en des emplacements prédéterminés du bus en anneau (RB) se trouvent disposés des points de séparation (1, 2, 3), à l'aide desquels une simulation de rupture d'une ligne peut être exécutée,

e) dans une phase d'apprentissage, lors de la mise en place de l'installation de traitement de données de mesure, on simule des interruptions de ligne à l'aide des points de séparation (1, 2, 3) de sorte qu'il est possible de localiser les points de séparation (1, 2, 3) et par conséquent, après la phase d'apprentissage, de localiser également des points de rupture respectifs (4).

2. Installation de traitement de données de mesure suivant la revendication 1, caractérisée par le fait que l'interface (IF) peut être raccordée à l'aide d'un commutateur (S) à l'une respective des deux jonctions (S1, S2) de sorte que l'on peut exécuter un contrôle séquentiel.

3. Installation de traitement de données de mesure suivant la revendication 1, caractérisée par le fait qu'une interface (IF1, IF2) est raccordée à chaque jonction (S1, S2) de sorte qu'on peut exécuter un contrôle en parallèle dans le temps.

4. Installation de traitement de données de mesure suivant la revendication 1 ou 3, caractérisée par le fait que :

chaque jonction (S1, S2) est reliée par l'intermédiaire d'une interface respective (IF1, IF2) et d'un dispositif respectif (BS1, BS2) de commande du bus, à l'installation centrale de traitement de données (EDV), auquel cas

les dispositifs (BS1, BS2) de commande du bus sont reliés entre eux de sorte qu'on peut réaliser une comparaison des résultats du contrôle.

FIG 1

FIG 2

FIG 3

FIG 4

FIG 5

FIG 6

FIG 7